# DEMANDE DE BREVET EUROPEEN

(11) **EP 3 672 386 A1**
(43) Date de publication de la demande: **24.06.2020**
(21) Numéro de dépôt: 19213483.1
(22) Date de dépôt: 04.12.2019
(51) Int. Cl.: H05K 9/00, H05K 7/14

(54) **ENSEMBLE ELECTRIQUE COMPRENANT DES MOYENS DE BLINDAGE ELECTROMAGNETIQUE INTEGRES**

(30) Priorité: 21.12.2018 FR 1874008
(71) Demandeur: Valeo Siemens eAutomotive France SAS, 95800 Cergy (FR)
(72) Inventeur: LEGENDRE, Alexandre, 95280 JOUY-LE-MOUTIER (FR); POUILLY, Aurélien, 78300 POISSY (FR)
(74) Mandataire: Argyma

(57) **Abrégé**

L'invention concerne un ensemble électrique destiné à être monté dans un équipement électrique, ledit ensemble comprenant
un premier sous-ensemble (1) comprenant un premier support (11) et une partie active (12), un deuxième sous-ensemble (2) comprenant un deuxième support (21) et une carte électronique (22) montée sur ledit deuxième support (21),
un troisième sous-ensemble (3) comprenant un troisième support (35),
ledit deuxième sous-ensemble (2) étant fixé au troisième sous-ensemble (3) et le premier sous-ensemble (1) étant fixé au deuxième sous-ensemble (2) de façon à former un ensemble électrique (100) solidaire
ledit ensemble comprenant un premier logement (A), logeant la carte électronique (22), intercalé entre le troisième support (35) et le deuxième support (21), et un deuxième logement, logeant la partie active (12), intercalé entre le deuxième support (21) et le premier support (11), lesdits logements (A, B) étant définis par des parois (211, 212, 311, 150, 250) réalisant des blindages électromagnétiques appartenant aux premier, au deuxième et au troisième supports (11, 21, 35).

## Description

### DOMAINE TECHNIQUE DE L'INVENTION

La présente invention se rapporte au domaine des équipements électriques, notamment haute tension, en particulier des onduleurs. La présente invention vise plus particulièrement le blindage électromagnétique dans de tels équipements électriques.

### ETAT DE LA TECHNIQUE

Selon l'état de l'art, il est connu d'assembler des équipements électriques, notamment des onduleurs pour des systèmes de motorisation de véhicules. De tels équipements électriques comprennent notamment des cartes électroniques (de contrôle, de pilotage, de filtrage), des barres de conduction électrique, des éléments capacitifs et des dispositifs de filtrage montés dans un boîtier fermé par un couvercle.

Ces composants électriques dans lesquels circulent des courants, notamment avec des puissances élevées, génèrent des champs magnétiques susceptibles de perturber le fonctionnement des autres composants. Le fonctionnement de chacun de ces composants est susceptible d'être affecté par de telles perturbations électromagnétiques. Il est bien entendu souhaitable de pallier ces perturbations.

Ainsi, comme cela est connu, de tels équipements électriques doivent présenter une bonne performance de compatibilité électromagnétique. Autrement dit, il faut s'assurer d'une part que l'équipement électrique est apte à fonctionner lui-même sans perturbations, dans son environnement électromagnétique, et d'autre part qu'il est apte également à fonctionner sans introduire de perturbations électromagnétiques susceptibles de nuire au bon fonctionnement d'équipements électriques tiers situés à proximité.

A cette fin, il est connu d'intégrer dans de tels équipements électriques une plaque support de blindage électromagnétique, notamment en aluminium. Typiquement, la carte électronique est montée sur une face de la plaque. En particulier, une telle plaque support de blocage électromagnétique sépare, d'un côté, un module électronique de puissance et, de l'autre une carte électronique de contrôle dudit module électronique de puissance.

Cela permet d'assurer un blindage électromagnétique vis-à-vis des perturbations électromagnétiques générées par le module électronique de puissance sur la carte électronique de contrôle. Toutefois, ce type d'équipement électrique comprend bien d'autres sources de perturbations électromagnétiques subies ou générés, notamment au niveau des barres de connexion électrique. Dans l'état de la technique, pour assurer un blindage électromagnétique satisfaisant, on recourt à des organes de blindage spécifiques, tels que des éléments mécaniques. On ajoute ainsi des boucliers électromagnétiques en différents lieux de l'équipement pour assurer un blindage vis-à-vis de certains composants.

Cependant, l'ajout de tels organes de blindage spécifiques n'est pas souhaitable, notamment car cela engendre davantage d'opérations lors de la fabrication de tels équipements électriques.

L'invention vise donc à proposer une structure d'équipement électrique intégrant des éléments de blindage électromagnétiques de façon native, au moyen de caractéristiques structurelles d'éléments constitutifs d'un tel équipement électrique.

### PRESENTATION DE L'INVENTION

A cette fin, la présente invention a pour objet un ensemble électrique destiné à être monté dans un équipement électrique, ledit ensemble comprenant :
un premier sous-ensemble comprenant un premier support et une partie active,
un deuxième sous-ensemble comprenant un deuxième support et une carte électronique configurée pour commander ladite partie active, ladite carte électronique étant montée sur ledit deuxième support,
un troisième sous-ensemble comprenant un troisième support, ledit deuxième sous-ensemble étant fixé au troisième sous-ensemble et le premier sous-ensemble étant fixé au deuxième sous-ensemble de façon à former un ensemble électrique solidaire,
ledit ensemble comprenant un premier logement, logeant la carte électronique, intercalé entre le troisième support et le deuxième support, et un deuxième logement, logeant la partie active, intercalé entre le deuxième support et le premier support, lesdits logements étant définis par des parois réalisant des blindages électromagnétiques, lesdites parois appartenant aux premier, au deuxième et au troisième supports.

Selon un mode de réalisation, au moins un desdits supports comprend une plaque de base, et au moins une paroi s'étendant orthogonalement vers le support le plus proche pour définir au moins en partie un desdits logements.

Selon un mode de réalisation, le deuxième support comprend au moins un premier muret s'étendant orthogonalement depuis une deuxième plaque de base du deuxième support vers le premier support, pour assurer un blindage électromagnétique du deuxième logement.

Selon un mode de réalisation, le troisième support comprend au moins un deuxième muret s'étendant orthogonalement depuis une troisième plaque de base du troisième support vers une surface inférieure de la deuxième plaque de base du deuxième support, pour assurer un blindage électromagnétique du premier logement.

Selon un mode de réalisation, au moins un desdits logement est défini au moins en partie par des parois s'étendant depuis des supports adjacents pour venir en vis-à-vis suivant une direction orthogonale aux deux parois.

Selon un mode de réalisation, le premier support présente, aménagée dans une surface inférieure d'une première plaque de base dudit premier support, une première nervure périphérique s'étendant vers le deuxième support et étant disposée en retrait du au moins un premier muret par rapport à un bord de la deuxième plaque de base, de manière à se trouver en vis-à-vis d'au moins une portion du au moins un premier muret, ladite au moins une première nervure périphérique présentant une hauteur supérieure à une distance entre ladite portion du au moins un premier muret et la surface intérieure de la première plaque de base.

Selon un mode de réalisation, le deuxième support présente, aménagée dans une surface inférieure de la deuxième plaque de base, une deuxième nervure périphérique s'étendant vers le troisième support et étant disposée en retrait du au moins un deuxième muret par rapport à un bord de la deuxième plaque de base, de manière à se trouver en vis-à-vis d'au moins une portion du au moins un deuxième muret, ladite deuxième nervure périphérique présentant une hauteur supérieure à une distance entre ladite portion du au moins un deuxième muret et la surface intérieure de la deuxième plaque de base.

Selon un mode de réalisation, le deuxième support comprend au moins un troisième muret s'étendant depuis la deuxième plaque de base vers le troisième support pour participer au blindage électromagnétique du premier logement.

Selon un mode de réalisation, les au moins un deuxième muret et au moins troisième muret sont disposés en quinconce.

Selon un mode de réalisation, les au moins un deuxième muret et au moins un troisième muret comprennent une portion en chevauchement.

Selon un mode de réalisation, le premier sous-ensemble comprend une première barre de conduction électrique destinée à relier ladite partie active à au moins une première borne de l'équipement électrique, ladite partie active et ladite première barre de conduction électrique étant montés sur ledit premier support.

Selon un mode de réalisation, le troisième sous-ensemble comprend une deuxième barre de conduction électrique, ladite deuxième barre de conduction électrique étant montée sur ledit troisième support, ledit au moins un premier muret s'intercalant entre la partie active et la deuxième barre de conduction électrique.

Selon un mode de réalisation, ledit troisième support forme un couvercle d'un boîtier d'un équipement électrique.

Selon un mode de réalisation, l'ensemble électrique comprend un boîtier définissant une cavité et comprenant une ouverture, et l'ensemble électrique comprend les premier, deuxième et troisième sous-ensemble, et est disposé dans ladite cavité de telle sorte que le troisième support ferme ladite ouverture dudit boîtier, formant ainsi un couvercle de l'équipement électrique.

La présente invention vise aussi un système électrique comprenant un premier équipement électrique tel que brièvement décrit ci-dessus, le boîtier du premier équipement électrique comprenant une seconde cavité recevant un deuxième équipement électrique.

Selon un mode de réalisation, le premier équipement électrique forme un onduleur et le deuxième équipement électrique forme un moteur électrique destiné à être commandé par ledit onduleur.

### PRESENTATION DES FIGURES

L'invention sera mieux comprise à la lecture de la description qui va suivre, donnée uniquement à titre d'exemple, et se référant aux dessins annexés donnés à titre d'exemples non limitatifs, dans lesquels des références identiques sont données à des objets semblables et sur lesquels :
Fig. 1A : la figure 1A représente un premier sous-ensemble d'équipement électrique, conformément à un exemple de l'invention ;
Fig. 1B : la figure 1B représente un deuxième sous-ensemble d'équipement électrique, conformément à un exemple de l'invention ;
Fig. 1C : la figure 1C représente un troisième sous-ensemble d'équipement électrique, conformément à un exemple de l'invention ;
Fig. 2 : la figure 2 illustre schématiquement un équipement électrique assemblé, selon un exemple de l'invention ;
Fig. 3 : la figure 3 montre une barrière électromagnétique formée par un muret et une nervure aménagés sur des supports superposés, dans un ensemble électrique selon un exemple de l'invention ;
Fig. 4 : la figure 4 illustre une disposition en quinconce de murets issus de supports superposés, dans un ensemble électrique selon un exemple de l'invention ;
Fig. 5 : la figure 5 montre une barrière électromagnétique formée par un chevauchement entre des murets aménagés sur des supports superposés dans un ensemble électrique selon un exemple de l'invention.

Il faut noter que les figures exposent l'invention de manière détaillée pour mettre en oeuvre l'invention, lesdites figures pouvant bien entendu servir à mieux définir l'invention le cas échéant.

### DESCRIPTION DETAILLEE DE L'INVENTION

Dans la description qui sera faite ci-après, l'invention sera décrite principalement en vue de la réalisation d'un onduleur, notamment destiné à alimenter une machine électrique telle qu'une machine électrique tournante d'un système de motorisation d'un véhicule. Toutefois, l'invention vise également tout équipement électrique compatible de la structure en trois sous-ensembles décrite ci-après.

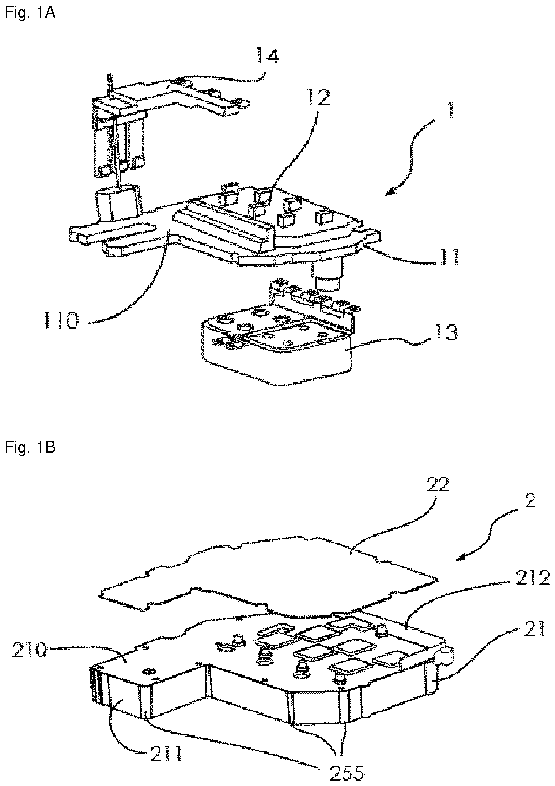

En référence aux figures 1A à 1C, il est représenté, à titre illustratif, trois sous-ensembles 1, 2, 3 formant un ensemble électrique selon un exemple de l'invention.

La figure 1A montre un premier sous-ensemble 1 comprenant un premier support présentant une première plaque de base 110, notamment, selon l'exemple représenté, un module de refroidissement 11 auquel est rapportée une partie 12 de l'équipement électrique. Le module de refroidissement 11 peut être un module actif comprenant un réseau de circulation de liquide de refroidissement, tel qu'une une boîte à eau par exemple. En particulier, la partie active 12 peut comprendre un module électronique de puissance d'un onduleur.

Un module électronique de puissance est notamment un ensemble comprenant une pluralité de puces semi-conductrices formant un circuit électrique, encapsulées dans une même enveloppe. En particulier, dans le présent contexte, le module électronique de puissance peut être un ensemble comprenant des composants par lesquels passe de l'énergie alimentant une machine électrique, par exemple un système de motorisation électrique, lesdits composants étant notamment destinés à transformer un courant continu en courants alternatifs ou vice-versa. Un tel module électronique de puissance est configuré pour permettre un passage commandé d'énergie électrique entre une batterie d'alimentation haute tension et la machine électrique..

Le premier sous-ensemble 1 peut également comprendre un dispositif de stabilisation 13, pour stabiliser un signal, notamment une tension, fourni à la partie active 12. Le dispositif de stabilisation 13 est notamment un élément capacitif de liaison, également désigné « DC-link capacitor » en anglais. Le dispositif de filtrage 13 est par exemple vissé sur le module de refroidissement 11 auquel est fixé le dispositif actif 12.

Le premier sous-ensemble 1 peut comprendre par ailleurs une première barre de conduction électrique 14, également désignée « busbar » en anglais. En particulier, l'ensemble électrique peut être un sous-ensemble d'un onduleur qui alimente un système de motorisation électrique polyphasé. Dans ce cas, la partie active 12 est un module électronique de puissance, comme expliqué précédemment, et une telle première barre de conduction électrique 14, reliée audit module électronique de puissance, est configurée pour recevoir des connecteurs de phases du système de motorisation électrique afin d'alimenter ledit système de motorisation électrique en énergie. On désigne alors couramment ladite première barre de conduction électrique 14 sous l'expression « AC busbar » en anglais.

La figure 1B montre un deuxième sous-ensemble 2 comprenant un deuxième support 21,. En particulier, une carte électronique 22 est fixée, notamment vissée, au deuxième support 21. La carte électronique 22 peut être une carte électronique de contrôle de l'onduleur, et notamment du module électronique de puissance 12. Cette partie du deuxième sous-ensemble 2, comprenant la carte électronique 22, correspond notamment à une partie basse tension de l'équipement électrique.

Notamment, le deuxième support 21 assure une fonction de bouclier électromagnétique, notamment pour protéger la carte électronique 22 de son environnement électromagnétique, en particulier du module électronique de puissance 12. Le deuxième support 21 est par exemple une pièce de fonderie constituée d'un matériau apte à assurer une fonction de barrière vis-à-vis des perturbations électromagnétiques. Par exemple, le deuxième support 21 est en aluminium.

Selon l'invention, le deuxième support 21 comprend une deuxième plaque de base 210 (également désignée « bracket » en anglais), plane, depuis laquelle peuvent s'étendre des murets 211, 212 et dans laquelle peut être aménagée une deuxième nervure périphérique, la deuxième nervure et lesdits murets étant disposés de façon à améliorer la performance de blindage électromagnétique de l'ensemble électrique, une fois les sous-ensembles assemblés, comme cela est décrit plus loin dans le présent document, comme cela sera détaillé ci-après. En particulier, la carte électronique 22 est monté sur la plaque de base 210.

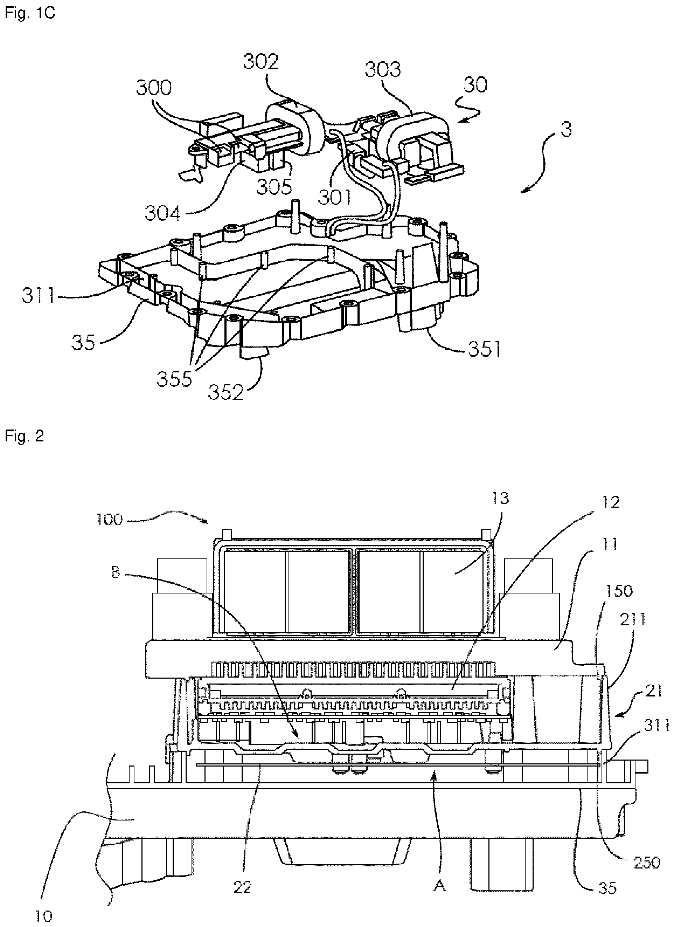

La figure 1C montre un troisième sous-ensemble 3 comprenant un troisième support 35 présentant une troisième plaque de base 310, ledit troisième support 35 étant par exemple destiné à assurer une fonction de couvercle de l'équipement électrique. Le troisième sous-ensemble 3 peut comprendre également une deuxième barre de conduction électrique 30 fixée, par exemple vissée, audit troisième support 35.

Par exemple, la deuxième barre de conduction électrique 30 peut comprendre des conducteurs électriques 300, également désigné « leadframe » en anglais, dans lesquels circule un signal électrique de puissance. Dans lesdits conducteurs électriques circule un signal, notamment un signal de puissance telle qu'une tension délivrée par une batterie d'alimentation haute tension.

La deuxième barre de conduction électrique 30 peut comprendre des éléments de filtrage dudit signal de puissance, à savoir, dans l'exemple représenté, au moins un tore de filtrage électromagnétique 302, 303 et au moins une capacité de décharge X, Y. Dans le cas où la deuxième barre de conduction électrique 30 reçoit un signal de puissance délivré par une batterie d'alimentation haute tension, les éléments de filtrage assurent le filtrage dudit signal de puissance.

La deuxième barre de conduction électrique 30 peut également comprendre un fusible 301 pour assurer une coupure de la conduction du signal de puissance en cas de dysfonctionnement. Le troisième support 35 peut comprendre par ailleurs des connecteurs électriques 351, 352.

Le troisième support 35 peut comprendre au moins un deuxième muret 311 qui s'étend orthogonalement à la troisième plaque de base 310. Ce au moins un troisième muret 311 participe au blindage électromagnétique de l'ensemble électrique, comme cela sera détaillé ci-après.

Les premier, deuxième et troisième sous-ensembles 1, 2, 3, comme cela est représenté sur la figure 2, sont empilés et fixés les uns aux autres. En particulier, le troisième sous-ensemble 3 reçoit le deuxième sous-ensemble 2 qui reçoit le premier sous-ensemble 1.

Plus précisément, le deuxième support 21 est fixé au troisième support 35. A cette fin, en particulier, le au moins un deuxième muret 211 qui s'étendent depuis le troisième support 35 vers le deuxième support comprennent des futs 355 dans lesquels sont engagées des vis pour fixer le deuxième support 21 au troisième support 35.

De façon similaire, le premier support 11 est fixé au deuxième support 21, par exemple au moyen de vis qui s'engagent dans des futs 255 aménagés dans le au moins un premier murets 211 qui s'étendent depuis le deuxième support 21 vers le premier support 11.

En référence à la figure 2, cet agencement engendre la création d'un premier et d'un deuxième logements A, B. En particulier, lesdits premier et deuxième logements A, B comprennent des composants électroniques. Notamment, le premier logement A peut comprendre au moins une carte électronique de contrôle 22. Le deuxième logement B peut comprendre un module électronique de puissance 12. Ladite carte électronique de contrôle 22 et ledit module électronique de contrôle 12 sont ainsi disposés de part et d'autre du deuxième support 21. Notamment, la carte électronique de contrôle 22 est fixée au deuxième support 21 de manière à se trouver du côté du troisième support 35 et le module électronique de puissance 12 est fixé au premier support 11 de manière à se trouver du côté du deuxième support 21.

Pour améliorer la performance de compatibilité électromagnétique, il est nécessaire de protéger l'équipement électrique, en particulier la carte électronique 22, vis-à-vis de perturbations électromagnétiques provenant de la partie active 12, des barres de conduction électrique 14, 30, ou de l'environnement dudit ensemble électrique, en particulier induit par des équipements électriques tiers destinés à fonctionner à proximité.

A cette fin, le deuxième support 21 comprend notamment au moins un premier muret 211, représenté sur les figures 1B, 2, 3, 4 et 5, s'étendant depuis la deuxième plaque de base 210 du deuxième support 21, pour participer au blindage électromagnétique du deuxième logement B.

Selon un mode de réalisation, au moins un troisième muret 212 s'étend depuis la deuxième plaque de base 210 du deuxième support 21 dans une direction opposée à celle dans laquelle s'étend le au moins un premier muret 211. Le au moins un premier muret 211 s'étend ainsi vers le module de refroidissement (premier support) 11 et le au moins un troisième muret 212 s'étend vers le couvercle (troisième support) 35.

Ainsi, par exemple, la carte électronique 22 est fixée d'un côté du deuxième support 21 et se trouve ainsi dans le premier logement A. Dans ce cas, le au moins un premier muret 211 s'étend orthogonalement à la deuxième plaque de base 210 dans une direction opposée au côté où se trouve la carte électronique 22 ; le au moins un deuxième muret 212 s'étend orthogonalement à la deuxième plaque de base 210 du côté où se trouve la carte électronique 22.

Le au moins un premier muret 210 participe donc au blindage électromagnétique du deuxième logement B et le au moins un troisième muret 212 participe au blindage électromagnétique du premier logement A.

Comme représenté sur les figures 1C, 2, 3, 4 et 5, au moins un deuxième muret 311 s'étend depuis une troisième plaque de base 310 du troisième support 35 vers le deuxième support 21.

Les au moins un premier muret 211 et au moins un deuxième muret 311 sont agencés pour assurer un blindage électronique pour les composants présents respectivement dans lesdits deuxième et premier logements B, A.

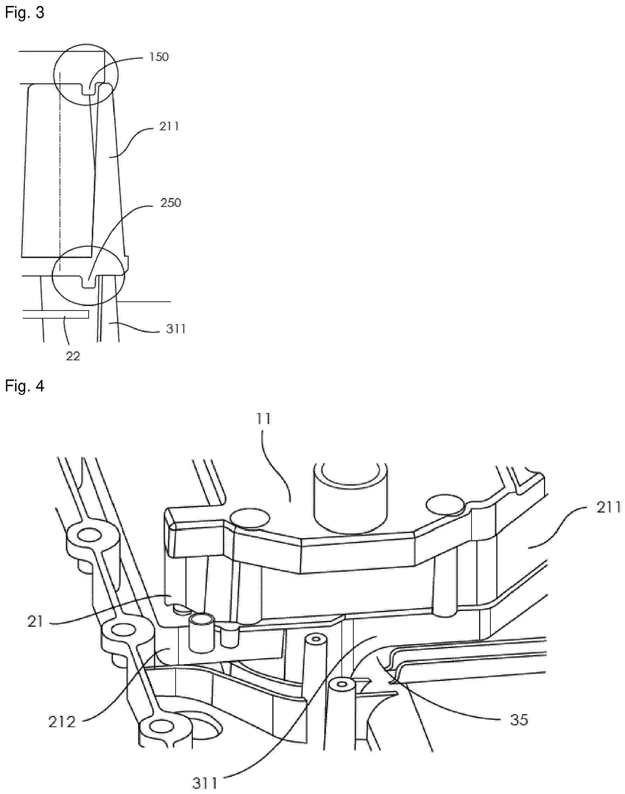

Selon un mode de réalisation représenté sur la figure 3, le au moins un deuxième muret 311 émanant du troisième support 35 coopère avec une deuxième nervure périphérique 250 aménagée depuis une surface inférieure de la deuxième plaque de base 210 du deuxième support 21, autrement dit sur le côté de la deuxième plaque de base 210 faisant face au troisième support 35.

Le au moins un deuxième muret 311 issu du troisième support 35 s'étend de sorte à venir au contact ou à proximité de la surface inférieure de la deuxième plaque de base 210 du deuxième support 21. Ladite deuxième nervure périphérique 250 et ledit au moins un deuxième muret 311 sont disposés de manière à former des chicanes vis-à-vis d'un champ électromagnétique provenant de l'extérieur et cherchant à pénétrer le premier logement A, et réciproquement.

Ainsi, la deuxième nervure périphérique 250 prévue sur la surface inférieure de la deuxième plaque de base 210 du deuxième support 21 est configurée pour se trouver immédiatement en retrait du au moins un troisième muret 311 par rapport au bord de la deuxième plaque de base 210, de manière à empêcher toute propagation de perturbations électromagnétiques à l'intérieur du premier logement A.

En effet, comme représenté sur la figure 3, le chemin pour accéder à l'intérieur du premier logement A forme une chicane, de sorte qu'un champ électromagnétique extérieur au premier logement A ne peut pénétrer à l'intérieur, et réciproquement.

Ainsi, même s'il existe un espace entre le au moins un deuxième muret 311 et la surface inférieure de la deuxième plaque de base 210, la présence de la deuxième rainure périphérique 250 en retrait permet d'empêcher la propagation de perturbations électromagnétiques depuis ou à destination du premier logement A. Cela permet de rattraper d'éventuels défauts de surface de la surface inférieure de la deuxième plaque de base 210 du deuxième support 21. A cette fin, la deuxième nervure périphérique 250 s'étend depuis la surface inférieure du deuxième support 21 vers le troisième support 35, légèrement en retrait par rapport audit au moins un deuxième muret 311 qui s'étend depuis le troisième support 35 vers le deuxième support 21, et présente une hauteur supérieure à la distance entre ledit au moins un deuxième muret 311 et ladite surface inférieure de la deuxième plaque de base 210 du deuxième support 21.

Dans l'exemple représenté, le couvercle (troisième support) 35 de l'équipement électrique comprend ainsi au moins un deuxième muret 311 qui s'élève vers le deuxième support 21. Ledit deuxième support 21 comprend une deuxième nervure périphérique 250 s'étendant depuis la surface inférieure de la deuxième plaque de base 210 vers le couvercle 35, légèrement en retrait par rapport audit au moins un deuxième muret 311, qui est configuré pour atteindre la surface inférieure du deuxième support 21 ou pour s'en trouver à une distance inférieure à la hauteur de ladite deuxième nervure périphérique 250.

De manière similaire, un blindage électromagnétique du deuxième logement B est assuré par le au moins un premier muret 211 s'étendant depuis le deuxième support 21 vers le premier support 11, ledit au moins un premier muret 211 coopérant, selon un mode de réalisation, avec une première nervure périphérique 150 aménagée depuis une surface inférieure de la première plaque de base 110 du premier support 11, ladite première nervure périphérique 150 s'étendant vers le deuxième support 21.

Le au moins un premier muret 211 issu du deuxième support 35 s'étend de sorte à venir au contact ou à proximité de la surface inférieure de la première plaque de base 110 du premier support 11. Ladite première nervure périphérique 150 et ledit au moins un premier muret 211 sont disposés de manière à former des chicanes vis-à-vis d'un champ électromagnétique provenant de l'extérieur et cherchant à pénétrer le deuxième logement B, et réciproquement.

Ainsi, la première nervure périphérique 150 prévue sur la surface inférieure de la première plaque de base 110 du premier support 11 est configurée pour se trouver immédiatement en retrait du au moins un premier muret 211 par rapport au bord de la première plaque de base 110, de manière à empêcher toute propagation de perturbation électromagnétique à l'intérieur du deuxième logement B.

En effet, similairement au schéma de la figure 3, le chemin pour accéder à l'intérieur du deuxième logement forme une chicane, de sorte qu'un champ électromagnétique extérieur au deuxième logement B ne peut pénétrer à l'intérieur, et réciproquement.

Ainsi, même s'il existe un espace entre le au moins un premier muret 211 et la surface inférieure de la première plaque de base 110, la présence de la première rainure périphérique 150 en retrait permet d'empêcher la propagation de perturbations électromagnétiques depuis ou à destination du deuxième logement B. Cela permet de rattraper d'éventuels défauts de surface de la surface inférieure de la première plaque de base 110 du premier support 11. A cette fin, la deuxième nervure périphérique 150 s'étend depuis la surface inférieure de la première plaque de base 150 du premier support 11 vers le deuxième support 21, légèrement en retrait par rapport audit au moins un premier muret 211 qui s'étend depuis le deuxième support 21 vers le premier support 11, et présente une hauteur supérieure à la distance entre ledit au moins un premier muret 211 et ladite surface inférieure de la première plaque de base 110 du premier support 11.

Dans l'exemple représenté, le deuxième support 21 de l'ensemble électrique comprend au moins un premier muret 211 qui s'élève vers le module de refroidissement (premier support) 11. Ledit module de refroidissement 11 peut comprendre une première nervure périphérique 150 s'étendant depuis la surface inférieure de la première plaque de base 110 vers le deuxième support 21, légèrement en retrait par rapport audit au moins un premier muret 211, qui est configuré pour atteindre surface inférieure du module de refroidissement 11 ou pour s'en trouver à une distance inférieure à la hauteur de ladite première nervure périphérique 150.

Comme représenté sur la figure 4, les au moins un deuxième muret 311 et au moins troisième muret 212 sont disposés en quinconce pour assurer le blindage électromagnétique du premier logement A.

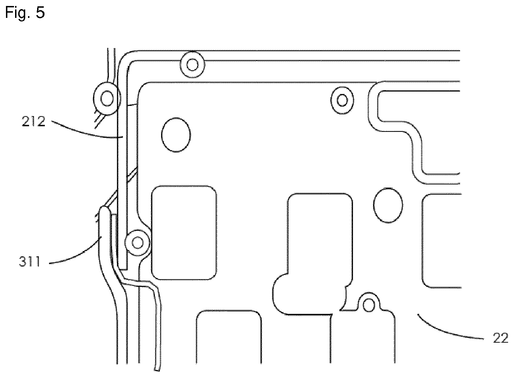

Par ailleurs, selon un mode de réalisation, comme représenté sur la figure 5, il peut avantageusement être prévu un chevauchement entre des portions de deuxième muret 311 s'étendant depuis le troisième support 35 vers le deuxième support 21 et des portions de troisième muret 212 s'étendant depuis le deuxième support 21, afin d'améliorer le blindage électromagnétique du premier logement A.

Autrement dit, des portions de recouvrement entre un troisième muret 212 du deuxième support 21 et un deuxième muret 311 du troisième support 35, lesdits deuxième et troisième supports 21, 35 étant superposés, peuvent être prévues. Par exemple, le au moins un deuxième muret 311 émanant du troisième support 35 peut présenter une portion avec une forme en Z, autrement dit présentant un décrochement configuré pour qu'une partie de ladite portion du au moins un deuxième muret 311 vienne en vis-à-vis d'une portion du au moins un troisième muret 212 émanant du deuxième support 21 et ainsi réaliser ledit chevauchement.

Il est précisé que des ouvertures peuvent être prévues dans des murets pour permettre le passage d'éléments de l'équipement, tels que des câbles ou des connecteurs.

Il est en outre possible qu'au moins une portion du au moins un deuxième muret s'étend au-delà de la deuxième plaque de base du deuxième support pour participer au blindage électromagnétique du deuxième logement.

Toujours dans le but d'amélioration de la compatibilité électromagnétique, selon un mode de réalisation, il n'y a de préférence pas de fût traversant reliant les trois sous-ensembles 1, 2, 3. Ainsi, des futs permettent de fixer le deuxième sous-ensemble 2 au troisième sous-ensemble 3, d'une part, et d'autres fûts permettent de fixer le premier sous-ensemble 1 sur le deuxième sous-ensemble 2. L'absence de fût traversant depuis le premier sous-ensemble 1 jusqu'au deuxième sous-ensemble 2 en traversant notamment le deuxième support 21 appartenant au troisième sous-ensemble 3 permet de minimiser la propagation de champs magnétiques, sources de perturbations électromagnétiques, depuis partie active 12 vers la deuxième barre de conduction électrique 30, et réciproquement.

## Revendications

1. Ensemble électrique destiné à être monté dans un équipement électrique, ledit ensemble comprenant
un premier sous-ensemble (1) comprenant un premier support (11) et une partie active (12),
un deuxième sous-ensemble (2) comprenant un deuxième support (21) et une carte électronique (22) configurée pour commander ladite partie active (12), ladite carte électronique (22) étant montée sur ledit deuxième support (21),
un troisième sous-ensemble (3) comprenant un troisième support (35),
ledit deuxième sous-ensemble (2) étant fixé au troisième sous-ensemble (3) et le premier sous-ensemble (1) étant fixé au deuxième sous-ensemble (2) de façon à former un ensemble électrique (100) solidaire
ledit ensemble comprenant un premier logement (A), logeant la carte électronique (22), intercalé entre le troisième support (35) et le deuxième support (21), et un deuxième logement, logeant la partie active (12), intercalé entre le deuxième support (21) et le premier support (11), lesdits logements (A, B) étant définis par des parois (211, 212, 311, 150, 250) réalisant des blindages électromagnétiques, lesdites parois appartenant aux premier, au deuxième et au troisième supports (11, 21, 35).

2. Ensemble électrique selon la revendication 1, dans lequel au moins un desdits supports (21, 35) comprend une plaque (210, 310) de base, et au moins une paroi (211, 311) s'étendant orthogonalement vers le support le plus proche pour définir au moins en partie un desdits logements (A, B).

3. Ensemble électrique selon la revendication 2, dans lequel le deuxième support (21) comprend au moins un premier muret (211) s'étendant orthogonalement depuis une deuxième plaque (210) de base du deuxième support (21) vers le premier support (11), pour assurer un blindage électromagnétique du deuxième logement (B).

4. Ensemble électrique selon les revendications 2 ou 3, dans lequel le troisième support (35) comprend au moins un deuxième muret (311) s'étendant orthogonalement depuis une troisième plaque de base (310) du troisième support (35) vers une surface inférieure de la deuxième plaque de base (210) du deuxième support (21), pour assurer un blindage électromagnétique du premier logement (A).

5. Ensemble électrique selon l'une des revendications précédentes, dans lequel au moins un desdits logement (A, B) est défini au moins en partie par des parois s'étendant depuis des supports adjacents pour venir en vis-à-vis suivant une direction orthogonale aux deux parois.

6. Ensemble électrique selon la revendication 5 combinée à la revendication 3, dans lequel le premier support (11) présente, aménagée dans une surface inférieure d'une première plaque de base dudit premier support (11), une première nervure périphérique (150) s'étendant vers le deuxième support (21) et étant disposée en retrait du au moins un premier muret (211) par rapport à un bord de la deuxième plaque de base (210), de manière à se trouver en vis-à-vis d'au moins une portion du au moins un premier muret (211), ladite au moins une première nervure périphérique (150) présentant une hauteur supérieure à une distance entre ladite portion du au moins un premier muret (211) et la surface intérieure de la première plaque de base (110).

7. Ensemble électrique selon la revendication 5 combinée à la revendication 4, dans lequel le deuxième support (21) présente, aménagée dans une surface inférieure de la deuxième plaque de base (210), une deuxième nervure périphérique (250) s'étendant vers le troisième support (35) et étant disposée en retrait du au moins un deuxième muret (311) par rapport à un bord de la deuxième plaque de base (210), de manière à se trouver en vis-à-vis d'au moins une portion du au moins un deuxième muret (311), ladite deuxième nervure périphérique (250) présentant une hauteur supérieure à une distance entre ladite portion du au moins un deuxième muret (311) et la surface intérieure de la deuxième plaque de base (210).

8. Ensemble électrique selon l'une des revendications 2 à 7, dans lequel le deuxième support (21) comprend au moins un troisième muret (212) s'étendant depuis la deuxième plaque de base (210) vers le troisième support (35) pour participer au blindage électromagnétique du premier logement (A).

9. Ensemble électrique selon la revendication 8 combinée à la revendication 4, dans lequel les au moins un deuxième muret (311) et au moins troisième muret (212) sont disposés en quinconce.

10. Ensemble électrique selon la revendication 8 ou 9, dans lequel les au moins un deuxième muret (311) et au moins un troisième muret (212) comprennent une portion en chevauchement.

11. Ensemble électrique selon l'une des revendications précédentes, dans lequel le premier sous-ensemble comprend une première barre de conduction électrique (14) destinée à relier ladite partie active (12) à au moins une première borne de l'équipement électrique, ladite partie active (12) et ladite première barre de conduction électrique (14) étant montés sur ledit premier support (11).

12. Ensemble électrique selon la revendication 3, dans lequel le troisième sous-ensemble (3) comprend une deuxième barre de conduction électrique (30), ladite deuxième barre de conduction électrique (30) étant montée sur ledit troisième support (35), ledit au moins un premier muret (211) s'intercalant entre la partie active (12) et la deuxième barre de conduction électrique (30).

13. Ensemble électrique selon l'une des revendications précédentes, dans lequel ledit troisième support (35) forme un couvercle d'un boîtier d'un équipement électrique.
